# EUROPEAN PATENT SPECIFICATION

(11) **EP 2 168 691 B1**
(45) Date of publication and mention of the grant of the patent: **17.08.2011**
(21) Application number: 08165315.6
(22) Date of filing: 26.09.2008
(51) Int. Cl.: B05D 3/06, B05D 7/24, B05D 7/04, H01J 37/077

(54) **Radiation cured coatings**
Strahlungsgehärtete Beschichtungen
Revêtements durcis par rayonnement

(43) Date of publication of application: 31.03.2010
(73) Proprietor: Camvac Limited, Thetford Norfolk IP24 3QY (GB)
(72) Inventor: Topping, John, Abingdon Oxfordshire, OX14 4BS (GB); Anthony, David, Brandon, Suffolk IP27 9AT (GB)
(74) Representative: Latham, Stuart Alexander

(56) References cited:
- EP-A- 1 155 818
- EP-A2- 0 423 499
- WO-A-03/049139
- WO-A-2005/021833
- WO-A1-2006/130122
- GB-A- 801 479
- US-A- 5 677 010
- SUGAI H ET AL: "GENERATION OF A LARGE ELECTRON BEAM FOR PLASMA PROCESSING" JAPANESE JOURNAL OF APPLIED PHYSICS, JAPAN SOCIETY OF APPLIED PHYSICS, TOKYO,JP, vol. 28, no. 5, PART 2, 1 May 1989 (1989-05-01), pages L868-L870, XP000030466 ISSN: 0021-4922

## Description

### Technical Field

This invention relates to coated substrates and apparatus and processes for coating substrates.

Films having enhanced barrier properties for oxygen or other gases or odours or water vapour are produced by depositing alternate layers of cured polymer and metal or compounds onto a web substrate using processes such as vacuum deposition. These films are useful for packaging of oxygen or moisture sensitive foodstuffs, encapsulation of gas or moisture sensitive components, and a variety of other functional applications requiring barrier properties. Films are also manufactured having an enhanced holographic effect, isotropic light scattering or colour shift by depositing alternate layers of a transparent or translucent cured polymer and a metal onto a web substrate.

It is known to deposit layers of cured polymer onto a web substrate using vacuum deposition. However, the existing sequential processes of vacuum condensation and curing of polymer precursors have a number of drawbacks/risks, associated with impurities in the commercial grades of raw materials used, particularly for the substrate, or inherent in the process itself. The risks associated with impurities, such as the inhibition of polymerisation of the condensate by oxygen adsorbed in the substrate and associated adhesion problems, or uneven wetting due to contaminants or low molecular weight species on the substrate surface, can often be alleviated by plasma treatment of the substrate before coating e.g. with a gas plasma. However, other problems inherent in the process are more difficult to overcome. For example:
- a): It is known that the condensate can re-evaporate before reaching the curing zone. This vapour can then potentially contaminate the pumps, or become entrained with the moving web, re-condense on the surface of the cured coating as an uncured, and therefore weak surface layer (giving poor adhesion of any subsequent coatings applied to the material).
- b): It is known that as the curing of the condensate only takes place within the zone of irradiation, at high line speeds (essential for an economically viable process), 100% polymerisation is difficult to achieve, particularly at the surface adjacent to the substrate and thus furthest from the radiation source. Increasing the radiation flux to increase curing can result in over-curing and embrittlement of the top surface of the coating closest to the radiation source, whilst still leaving the bottom surface under-cured and with poor adhesion. It is difficult therefore to achieve the homogeneity of curing through the thickness of the coating desirable for good mechanical strength, adhesion or barrier.
- c): It is known that if the precursor vapour or atomised liquid is passed through the radiation flux prior to delivery on the substrate, it can partially polymerise, giving rise to a non-homogeneous and mechanically weak coating with poor adhesion. This phenomenon is known in the art as "snowing".
- d): It is known that if the coating is cured using a charged radiation flux, such as a high energy electron beam, the resultant coated web can "block" (i.e. stick to itself) when it is wound up into a roll, and then later tear when it is unwound. The risk of damage on unwinding is further accentuated by poor homogeneity through the coating.
- e): It is known that the surfaces of cured films produced by the processes already known in the art have to be further treated (e.g. with a plasma) before they can be further coated.

Various radiation sources have been used to cure polymer precursors once condensed on a substrate, for example ultraviolet, visible or infra-red or, particularly, electron beam radiation. However, the electron beams currently used in the art for primary curing have very high energy levels (generally >300eV), as this is considered necessary to achieve sufficient polymerisation. Atmospheric plasmas are also used, generally for secondary curing (i.e. as an adjunct to electron beam, to complete the cure). Again, these have high energy levels, and high ionisation fractions, and the prior art teaches that this high level of ionisation is essential for polymerisation.

It is also known to pass a monomer vapour through a low pressure glow discharge containing a high level of free radicals and then direct it towards the substrate using a driving voltage in the glow discharge which is positive with respect to the local conditions at the substrate. The monomer containing these free radicals then condenses on the substrate, where the free radicals initiate curing.

Document GB801479 discloses the electron beam curing of coating composition at an energy of 15-50000 eV (examples at 10 keV and 25keV); WO2006/130122 discloses the thermal treatment of a functionalised polymer surface with electron beam at an energy of 1000 eV; EP0423499 discloses electron beam treatment to improve adhesiveness of a polymer surface at an energy of 200 eV.

### Disclosure of the Invention

The invention comprises a process according to claim 1.

The energy level 6.5eV is that needed to break a carbon-carbon double bond in unsaturated precursor materials, such as acrylates, in order to induce polymerisation. Preferably, the electron flux energy range is between 6.5eV and 100eV.

The electron flux is directed at the substrate either simultaneously or sequentially with delivery of the precursor material. In the former case, curing is preferably initiated spatially and temporally concurrently with delivery of the precursor material to the substrate, which avoids the need for the electron flux to penetrate the condensed precursor material in order to cure it.

Despite the fact that low pressure gas plasmas have significantly lower energy levels (<300eV) than electron beams, atmospheric plasmas etc it has been found that effective curing can be achieved.

Preferably, the low pressure gas plasma is magnetically enhanced by, for example, incorporating crossed magnetic and electric fields to form a magnetron. A cathode is provided in the form of a sputter cathode or polarised reaction plate. A negative polarity on the cathode and the relative positive polarity of the surroundings or substrate (possibly positive or earthed), drive the required electron flux. Alternatively, a high frequency AC discharge signal may be applied to the substrate, and the physical nature of the self bias and the very low time period of the AC source produces the appropriate polarity at the substrate.

Embodiments of the invention serve to reduce the risk of re-evaporation and "snowing" and produce a more homogenously cured coating. The tendency to "blocking" is reduced, and the substrate surface does not need further treatment before recoating. The process of the invention can therefore be run at higher line speeds, thereby reducing unit production costs.

### Description of the Drawings

Figure 1 is a schematic drawing of apparatus for carrying a process according to a first embodiment of the invention;
Figure 2 is a schematic drawing of apparatus for carrying out a process according to a second embodiment of the invention;
Figure 3 is a schematic drawing that illustrates the radiation and vapour flows in Figure 1;
Figure 4 is a schematic drawing that illustrates a plasma source for use in Figures 1 to 3;
Figures 5a and 5b are schematic drawings that illustrate a precursor source for use in Figure 1 to 3;
Figure 6 is a schematic drawing that illustrates an alternative precursor source for use in Figures 1 to 3;
Figure 7 is a schematic drawing that illustrates another alternative precursor source for use in Figures 1 to 3, and
Figure 8 is a schematic drawing showing configuration for sequential delivery and cure.

### Embodiments of the Invention

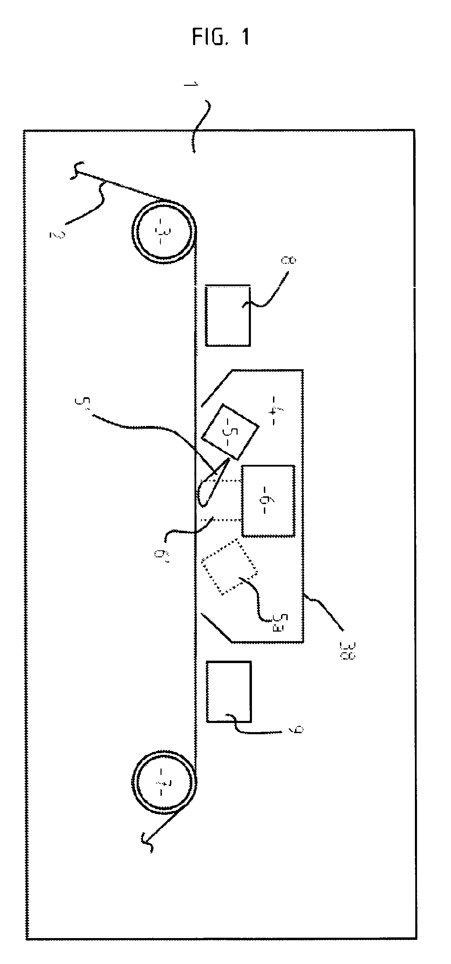

The apparatus in Figure 1 is housed in a vacuum chamber 1. A web 2 to be treated is fed over idle rollers 3, 7 between web unwind and rewind stations (not shown). The web is fed past a deposition station 4 defined by an enclosure 38 in which is housed a device 5 that generates a directional beam 5' of a radiation curable material, and a low pressure gas plasma source 6 that generates a directional electron flux 6'. The flux 6' may comprise electrons and other negatively charged or non-charged particles and species 6' but the electron flux is the primary curing agent. The ionisation fraction of the plasma might typically be 10⁻⁵ to 10⁻¹. The beam of radiation curable material, such as a polymer precursor vapour or atomised liquid, is directed at the web 2 as it passes below device 5, and the plasma source 6 simultaneously directs the electron flux 6' at the web 2 to be incident on the web generally concurrently with the beam 5'. The beam 5' and flux 6' overlap so that the overlap region is exposed to the electron radiation during delivery, thereby to initiate curing as the vapour is delivered to the web 2. The enclosure 38 serves to support a differential pressure between the inside of the enclosure and the vacuum chamber 1 so as to control escape of the precursor vapour and process gases outside of the enclosure. The apparatus can optionally have surface treatment stations 8 and 9 to enhance the properties of the web prior to and after the deposition station 4.

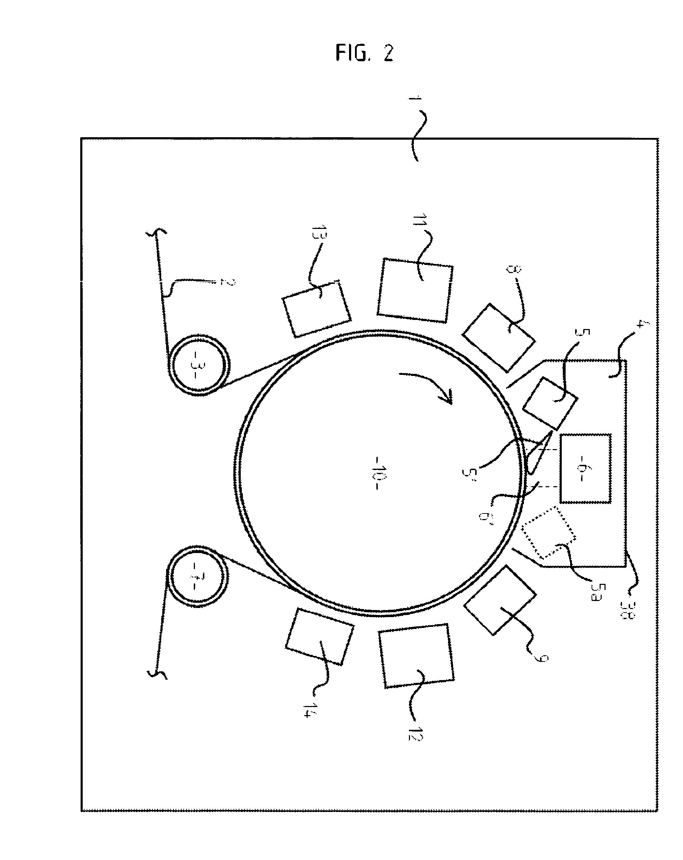

An alternative embodiment of the invention is illustrated in Figure 2 in which the linear feed of the web 2 between rollers 3, 7 is supplemented by a rotating drum feed 10. The rotating drum 10 allows additional treatment processes to take place, e.g., further depositing stations 11, 12 for coating metallic or non-metallic compounds before and after the deposition station 4, and treatment stations 13, 14 to enhance the properties of the film before and after the optional depositing stations 11 and 12.

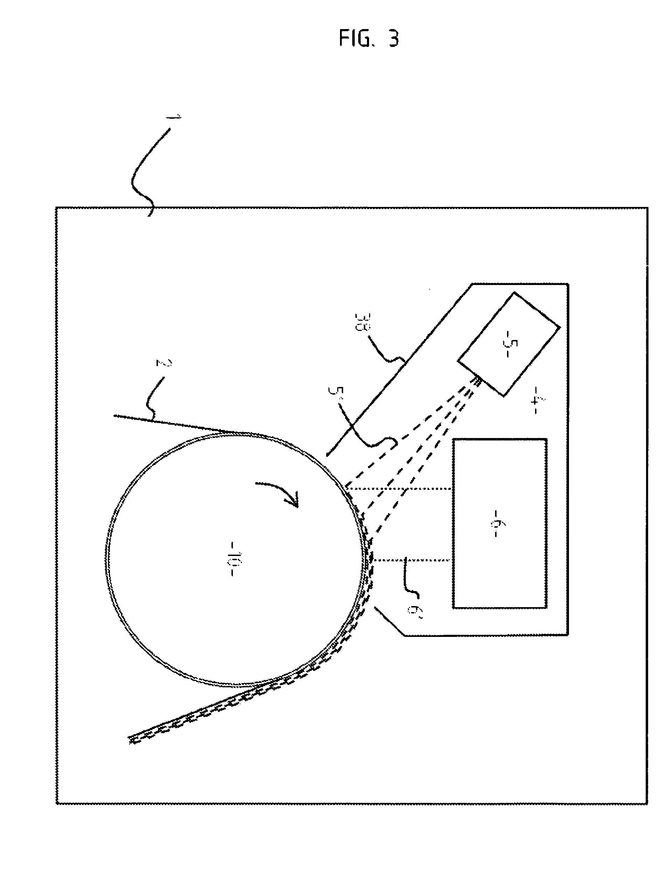

Figure 3 shows the pattern of the precursor beam 5' and electron flux 6', and how these beams overlap in space and are incident concurrently on the web 2 so that a coating is progressively deposited and cured as the web passes the deposition station 4.

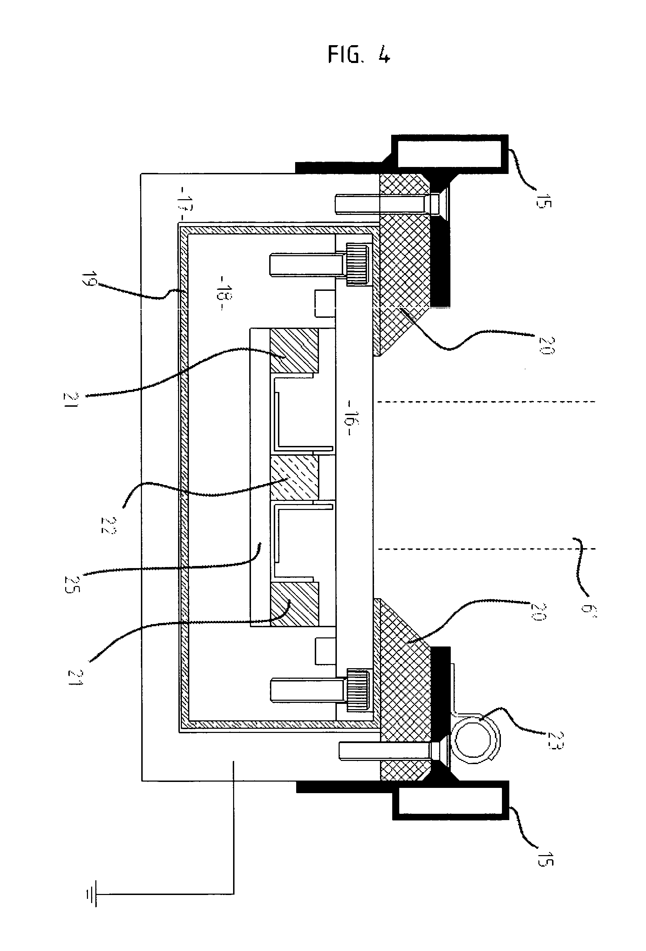

Figure 4 shows a low pressure gas plasma source 6 suitable for use in the embodiments described herein. The plasma is generated between an anode element 15, which is water cooled, and a reaction plate 16. An outer core 17 is insulated from a cathodic inner core 18 by an insulating layer 19. Spatial separation between the anode and cathode is supplied by insulators 20. Magnets of a magnetron are arranged with an outer set 21 in opposite polarity to a centre set 22 on a yoke plate 25 to which they are magnetically attached to create a magnetic field to trap the ionised gas. A plasma gas is supplied to the plasma area from a gas inlet pipe 23. The magnets 21, 22 operate as a magnetron to enhance ionisation of the plasma in the glow discharge in the region of the reaction plate 16. A driving voltage is applied to the cathode 18 which is negative relative to the web 2 so as to direct the electron flux 6' towards the web 2.

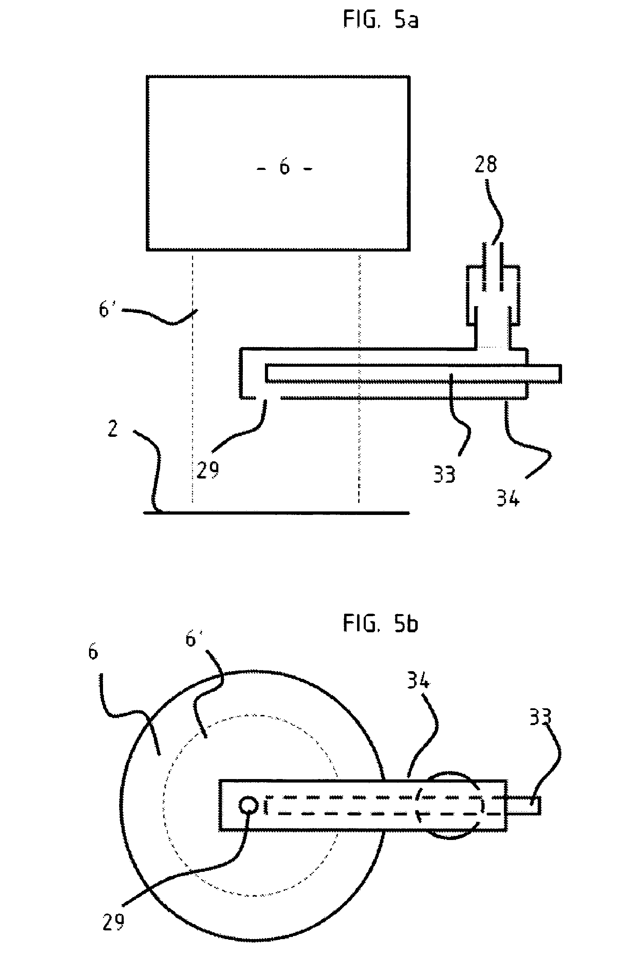

Figures 5a and 5b show a device 5 suitable for use in the embodiments described herein to generate a beam of vapour precursor. The radiation curable material is fed into the device via a delivery pipe 28. This delivers the radiation curable material into a heated chamber 34, which is heated by a cartridge heater 33 up to its operating temperature. The radiation curable material then effuses out of the outlet hole 29 whereupon it will arrive at the web substrate 2 to be cured by the electron flux 6'.

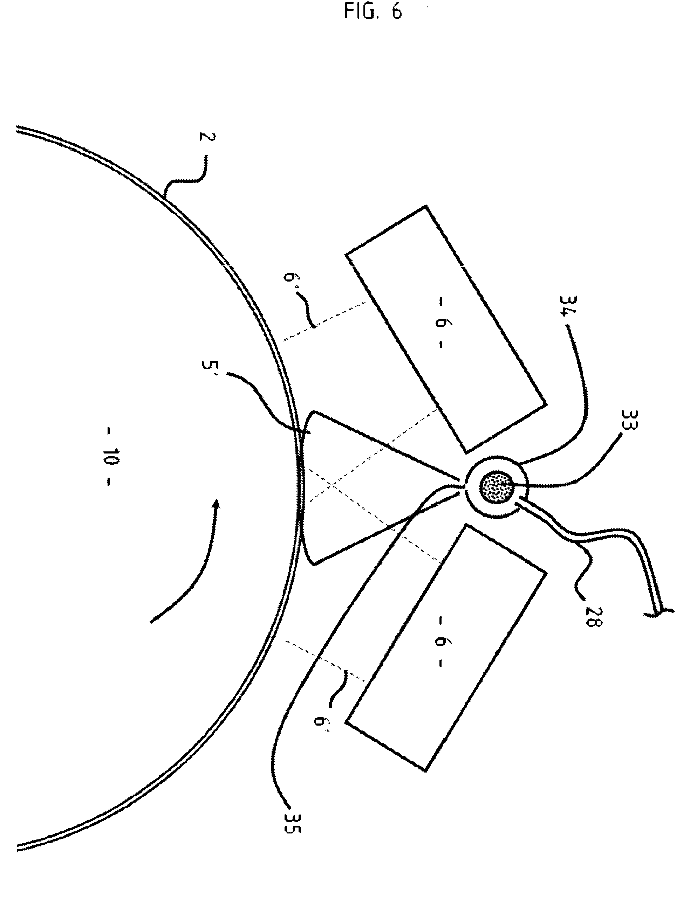

Figure 6 shows an alternative device 5 to that of Figures 5a, 5b, which is suitable for use in the embodiment of Figure 2. The components are similar except that the heated chamber 34 extends substantially parallel to the axis of the drum 10 above its surface, and an outlet slot 35 is formed along the length of the chamber 34 to direct a beam of precursor vapour at the web on the surface.

As shown in Figure 6, the device 5 directs a vapour beam 5' radially of the drum 10 towards the web 2, and a source of radiation flux 6 is located one each side of the source 5 to direct a flux 6' towards the web 2 and to each overlap with the beam 5' at either side, thereby ensuring that all of the vapour is irradiated during delivery to the web.

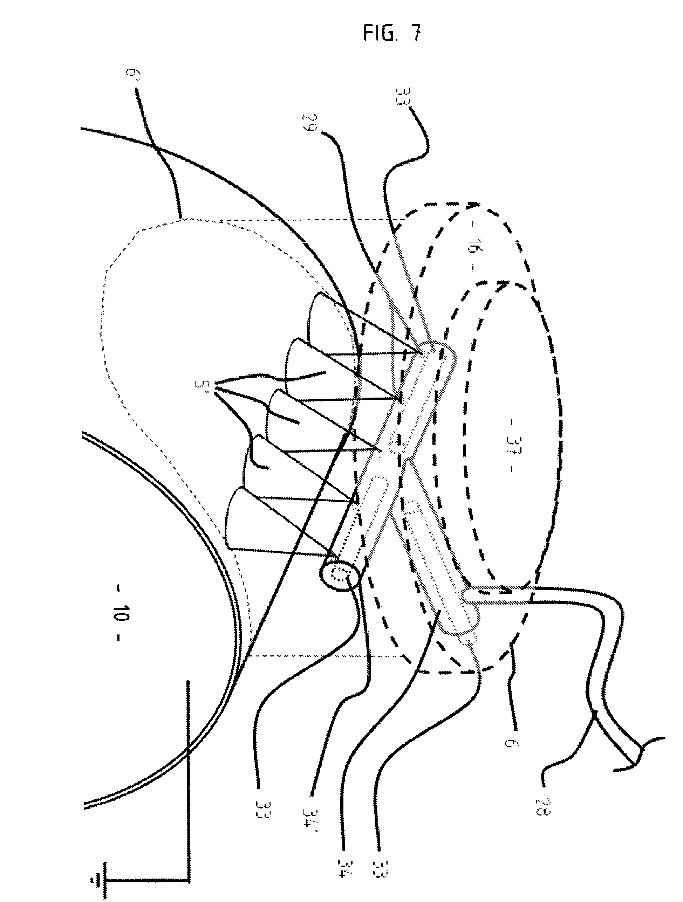

Figure 7 shows yet another alternative device to deliver a precursor vapour to the web 2. The radiation curable material is fed into the device via a delivery pipe 28. This delivers the radiation curable material into a 'T-shaped' heated chamber 34, which is heated by three cartridge heaters 33 up to its operating temperature. The radiation curable material then effuses out of the holes 29 along the crosspiece 34' of the 'T- shape', which extends substantially parallel to the axis of the feed drum 10. Figure 7 shows a low pressure plasma source 6 located over the delivery pipe 28 to deliver an electron flux 6' to the web on feed drum 10. The source 6 is similar to that of Figure 4 but has modified diode system with an enlarged reaction plate 16 to produce a lower density electron flux, the flux being indicated by the lines 6'.

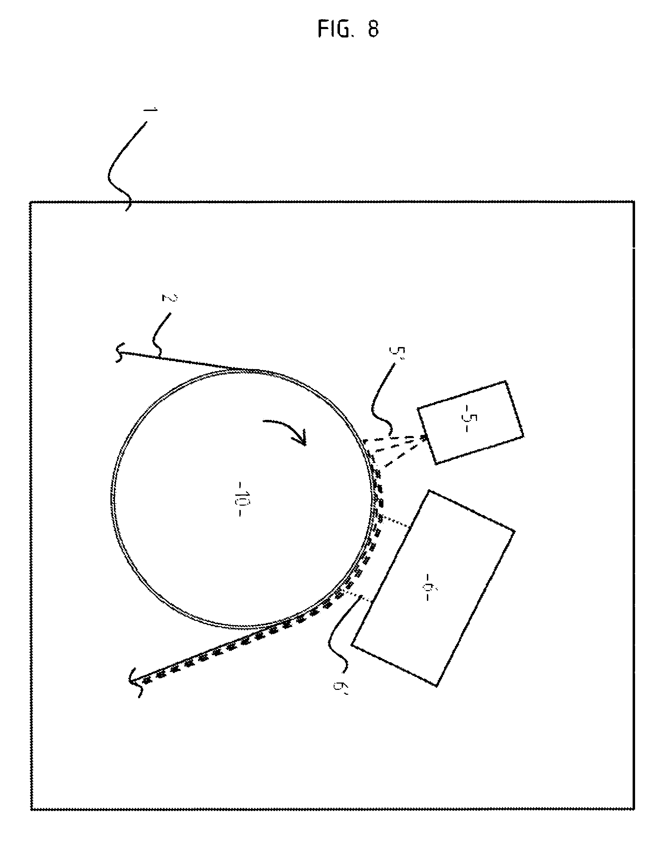

Figure 8 shows an embodiment of the invention in which the deposition device 5 has been repositioned away from the electron flux source 6. In Figures 1 to 7, the deposition and curing occurs concurrently in space and time onto the web 2, whereas in this embodiment, the web 2 first passes the deposition beam 5 and transports the uncured deposited material to the electron flux 6' to be cured. Although the devices 5' and 6 are still active concurrently in time, they are acting sequentially upon the web 2, and so the respective beams 5' and 6' are not concurrent spatially.

As shown in Figures 1 and 2, the device 5 may be relocated relative to the radiation source 6 so that it is downstream rather than upstream of the radiation 6 in the movement of the web. However, the precursor beam 5' would still be angled to overlap the electron flux 6' in a similar manner shown in Figure 3.

A low pressure gas plasma is the preferred source 6 of the irradiation flux, and as such, the pressure of this process will determine not only the mean free path of any molecule within the plasma zone, but also the electron energy dependent upon the electric field used. Reference Handbook of Plasma Processing Technology pages 38-43 (ISBN0-8155-1220-1). The electron energy does not generally exceed 300eV under the pressure regimes used in commercially available plasma sources.

The devices 5 delivering the beam 5' should be positioned so that the mean free path is greater than or comparable to the distance the vapour must travel from the device 5 before it condenses on the substrate to be coated.

The delivery of the precursor beam to the substrate should also allow for a high degree of irradiation. This irradiation is generally maximised directly in front of the reaction plate 16 that causes the plasma to be excited. Often magnetic fields are introduced that concentrate the irradiation within what is termed, the 'race track'. In such systems the area of highest irradiation flux is directly opposite these 'race track' zones. Therefore, the vapour should preferably be directed into these zones.

By following these design rules, it is possible to design the geometry of a system so that the radiation and vapour fluxes are matched for the desired amount of curing.

In embodiments of the invention, the delivery point of the vapour is typically 50mm from the surface to be coated, and is placed adjacent to the source of the radiation flux so that when angled, the distance the vapour has to travel to interact with the maximum radiation zone is approximately 75mm. This distance is comparable to the mean free path at the process pressure of 5x10-3mbar. However, the invention is not limited by these parameters and if higher process pressures were used this would still allow for a portion of the vapour to be incident upon the substrate in the maximum irradiation zone and to be cured.

Most commercially available designs of low pressure gas plasma sources can be used to produce the electron flux. In a preferred embodiment of the invention, the electron flux is provided by a detuned magnetron such as shown in Fig 4.

The functional element of the precursor is any unsaturated material capable of being vapourised or atomised and sprayed onto the substrate, and also capable of being polymerised by electron radiation. Precursors can be organic or inorganic and include unsaturated organic materials, silicon-based materials, halogen-based materials, organometallic composites etc, with acrylates such as tripropylene glycol diacrylate or isobornyl acrylate being preferred. Most polymerisable materials described in the art can be used in the process. The vapourised or atomised material may optionally include other radiation curable or non-curable components to provide functionality such as adhesion promotion, dimensional stability, mechanical properties, colour, electrical conductivity etc.

Any web substrate which can be handled by the equipment can be used in the invention. Substrates can include a wide variety of commercially available thermoplastic films (including polyesters such as polyethylene terephthalate (PET) or polyethylene naphthalate (PEN) or blends or coextrusions thereof), polyamides (including nylon 6 and nylon 6.6), polyolefines (including polypropylene and high and low density polyethylene) and other thermoplastic films known in the art. Non-thermoplastic films, including biodegradable films and films derived from renewable resources, such as polylactic acid or cellulose-based materials may also be used. Thermoset polymer films, such as polyimides may also be used. Fibrous or woven substrates (such as paper or textiles) may also be used. The invention is not limited by this list of web substrates.

The substrate can optionally be pre-coated, vacuum deposited or printed with a wide variety of metals, metallic or non-metallic compounds and other materials, in order to achieve desired properties or effects. For non-transparent barrier applications, for example, substrates such as polyester films coated with a metal such as aluminium are especially preferred. For transparent barrier applications, substrates such as polyester films coated with a transparent metallic or non-metallic oxide, nitride or other compound (e.g. oxide of aluminium or oxide of silicon) are especially preferred. For electrical or electronic applications, the web substrate may be optionally pre-coated with a metal such as copper or another conductive inorganic or organic material, which however may be transparent or non-transparent. However, the invention is not limited to these specified coatings.

It is known that an optically variable colour shift coating can be produced by depositing a reflective coating, such as a metal or a high refractive index material, on a web substrate, and then applying over it a further coating of a transparent or translucent material, having an optical thickness from 1/4 to 1/2 the wavelength of visible light (380nm-760nm). The colour shift effect can be further enhanced by depositing on top of said transparent material a further semi-transparent layer of metal or high refractive index material. The transparent or translucent layer can be a radiation-cured organic polymer deposited and cured using a sequential delivery and curing process. It has now been found that if this transparent or translucent layer is produced using the process of the invention, the coating contains a mixture of dielectric domains and has a holographic-like iridescent appearance, and the intensity of colour and the degree of the colour shift in any continuously optically variable device are enhanced.

The thickness of the cured polymer coating can be in the range 0.001 µm - 50µm, and preferable 0.1 µm to 50µm, the preferred thickness largely being decided on the basis of the function of the polymer layer in the intended application, and cost constraints, rather than constraints arising from the process. For example, for barrier packaging applications, the function of the polymer layer is to protect the barrier coating (i.e. the aluminium or aluminium oxide) against physical damage or abrasion. In this case, the lower limit of thickness of the polymer layer is around 0.02µm, as below this there is insufficient protection. The upper limit may be subjective, as above about 1µm, the benefit of mechanical protection will begin to be outweighed by the risk of delamination. For very high barrier applications, a plurality of barrier layers, separated by polymer layers, is used, as this extends the diffusion pathway for gas or vapour between the permeable defects in each barrier layer. In this case, since the polymer layer is functioning as a separating layer between two metal or ceramic layers, and has little or no inherent barrier of its own, it should preferably be as thin as practicable conducive with the requirements that it should be continuous (with no voids or defects) and have good surface smoothness (to maximise barrier of the second barrier layer). For optically variable devices, the function of the polymer layer is to generate light interference, and thus produce a "colour shift". For such applications, a coating thickness of approximately a quarter to half of the wavelength of the incident light is preferred but the invention is not limited by this thickness.

Various examples of polymer coating processes according to the invention are now described in more detail.

### Example 1

In this example, a planar magnetron low pressure plasma source was used for curing comprising an Edwards 75mm planar magnetron and MDX DC power supply; in the treatment space, an acrylate delivery source was located between the plasma source and the substrate, and the delivery was directed away from the plasma source towards the substrate. The acrylate used was tripropylene glycol diacrylate TRPGDA. The substrate was static for deposition and curing. A single hole heated precursor delivery pipe was placed in-front of the source facing toward the substrate, as in the manner of Figures 5a, 5b. The pipe was heated using a variable heating supply 200 watts at 240 volt (mark space modulation, 10% duty cycle) for 8 minutes. The cathode was run in constant current mode at a current of 200mA using residual ambient air at 6 x 10-2 mbar. 8ml of material was delivered in 3 seconds and the resulting substrates were coated with cured acrylate that had excellent adhesion.

### Example 2

In this example, two dual planar magnetrons were used with plasma delivery between them in the manner of Figure 6. Power was supplied by a DC magnetron power supply unit. The PID controlled heated pipe had internal baffles, and the precursor TRPGDA was delivered to the pipe on the opposite side to the moving web. A 30mm slot machined in the pipe facing the moving web provides the output precursor beam. With DC powers in excess of 200watts on the two 2 inch diameter cathodes, these were arranged 60mm above the 150mm coating drum that carries the moving web. At pressures of 2 x 10⁻² mbar of argon and the 20mm diameter heated delivery pipe fitted within the 25mm space between the cathodes and, with the 20mm slot positioned 50mm from the web, 0.2ml of precursor was delivered in 1.5 minutes through the 20mm slot aligned to intersect with a substantial proportion of the electron flux from the two cathodes at the substrate surface. The substrate was coated at 30 meters per minute giving a well defined TRPGDA coating with excellent adhesion.

### Example 3

In this example, the apparatus of Figures 5a and 5b was used. The plasma source is a 4 inch sputter cathode with very weak magnetic field and a 6 inch (oversize) reaction plate. The precursor source comprised a heated precursor delivery pipe (3/4 inch diameter) with 4mm exit aperture in-front of the 6 inch cathode surface, centrally mounted with exit aperture facing the web 20mm below cathode, 30mm from the web surface and using oxygen /nitrogen atmosphere at 3x 10⁻¹ mbar. The cathode was run at 150 watts and the pipe heated to 260 degrees C with the delivery of liquid acrylate 4 inches away from the 4mm pipe exit and 180 degrees opposite the exit aperture. The acrylate was delivered through a needle metering valve and the resulting coating was well cured acrylate deposition with excellent adhesion and good uniformity in the machine and transverse directions.

### Example 4

The apparatus of Figure 1 was used. The plasma source comprised rectangular planar cathode, 8 inch by 4 inch reaction plate with 50mm wide racetrack. The precursor source comprised an aluminium precursor delivery nozzle with integral cartridge heater. Acrylate delivery was into a machined cavity within the delivery nozzle that provides a tortuous path such that there was no direct path from the vaporisation zone to the delivery. The machined cavity was also chosen so that from the vaporisation zone to the delivery zone (a slot 80% of the width of the nozzle body), the calculated path lengths allowed for even distribution of acrylate onto the web. This nozzle was placed next to the rectangular cathode and positioned so that the acrylate vapour jet interacted with the moving web under the race track zone maximising the coincidence between radiation flux from the cathode plasma and the acrylate vapour deposition. This system was run with a nozzle operating temperature of 260°C minimum: 5x10⁻² mbar chamber pressure; and magnetron power of 250 watts resulting in a uniform coating, with excellent adhesion, achieved at acrylate delivery rates up to 5ml per min and web speeds up to 60 meters per min.

Materials manufactured by the invention are suitable for use in multiple different applications including: packaging applications; abrasion-resistant material or intermediate (in which the polymer coating prevents abrasion damage to any underlying functional layers during conversion or use); security or anti-counterfeit applications, including continuously optically variable devices; decorative applications, including continuously optically variable devices; functional industrial applications; and electrical or electronic applications (inclusive of static electricity dissipation).

## Claims

1. A process for coating a substrate (2) comprising condensing a radiation curable material (5') on the substrate, **characterised by** curing said material with an electron flux (6') having an energy between 6.5eV and 300eV, the electron flux being extracted from a low pressure gas plasma.

2. A process as claimed in claim 1 in which the electron flux (6') is directed at the substrate (2) substantially simultaneously with delivery of the material to said substrate, so that curing is initiated spatially and temporally substantially concurrently with the delivery of the material to the substrate.

3. A process as claimed in claim 1 in which the electron flux (6') is directed at the substrate (2) substantially sequentially with condensation of the material on said substrate.

4. A process as claimed in any of claims 1 to 3 in which the electron flux (6') is derived from a low pressure gas plasma with an driving voltage that is negative relative to the substrate.

5. A process as claimed in claim 4 in which the low pressure gas plasma is magnetically enhanced.

6. A process as claimed in claim 5 in which the low pressure gas plasma is generated using a magnetron.

7. A process as claimed in claim 2 in which substantially all of the radiation curable material (5') passes through the flux (6') prior to condensing on the surface of the substrate.

8. A process as claimed in any of the preceding claims in which the substrate (2) comprises a web which is composed of a plastics film;
or is composed of polyester or polyethylene terephthalate or polyethylene naphthalate or a mixture of polyethylene terephthalate and polyethylene naphthalate;
or is composed of or a polyolefin or a polyamide;
or is obtained from a renewable resource or polylactic acid or a cellulose; or comprises a fibrous material, paper or textile.

9. A process as claimed in any of claims 1 to 7 in which the substrate (2) comprises a plastics film which is pre-coated with:
an inorganic barrier material, a metal or aluminium; or
an oxide of aluminium or an oxide of silicon; or
a conductive organic or inorganic material or copper.

## Patentansprüche

1. Verfahren zum Beschichten eines Substrats (2), umfassend das Abscheiden eines strahlungshärtbaren Materials (5') auf dem Substrat, **dadurch gekennzeichnet** durch das Härten des Materials mit einem Elektronenfluss (6'), der eine Energie zwischen 6,5 eV und 300 eV aufweist, wobei der Elektronenfluss aus einem Gasplasma niedrigen Drucks abgezogen wird.

2. Verfahren nach Anspruch 1, bei dem der Elektronenfluss (6') im Wesentlichen gleichzeitig auf das Substrat (2) gerichtet wird mit der Zuführung des Materials zum Substrat, so dass die Aushärtung räumlich und zeitlich im Wesentlichen gleichzeitig mit der Zuführung des Materials zum Substrat eingeleitet wird.

3. Verfahren nach Anspruch 1, bei dem der Elektronenfluss (6') im Wesentlichen aufeinander folgend auf das Substrat (2) gerichtet wird mit der Zuführung des Materials zum Substrat.

4. Verfahren nach einem der Ansprüche 1 bis 3, bei dem der Elektronenfluss (6') aus einem Gasplasma niedrigen Drucks mit einer Betriebsspannung abgezogen wird, die in Bezug auf das Substrat negativ ist.

5. Verfahren nach Anspruch 4, bei dem das Gasplasma niedrigen Drucks magnetisch angereichert wird.

6. Verfahren nach Anspruch 5, bei dem das Gasplasma niedrigen Drucks unter Verwendung eines Magnetrons erzeugt wird.

7. Verfahren nach Anspruch 2, bei dem im Wesentlichen das gesamte strahlungshärtbare Material (5') vor der Abscheidung auf der Oberfläche des Substrats durch den Elektronenfluss (6') gelangt.

8. Verfahren nach einem der vorherigen Ansprüche, bei dem das Substrat (2) eine Bahn ist, die aus einem Kunststofffilm besteht
oder aus einem Polyester oder Polyethylenterephthalat oder Polyethylennaphthalat oder einer Mischung aus Polyethylenterephthalat und Polyethylennaphthalat besteht
oder aus einem Polyolefin oder einem Polyamid besteht
oder aus einer erneuerbaren Resource oder Polymilchsäure oder einer Cellulose erhalten wird oder
ein Fasermaterial, Papier oder Textil umfasst.

9. Verfahren nach einem der Ansprüche 1 bis 7, bei dem das Substrat (2) einen Kunststofffilm umfasst, der vorbeschichtet ist mit:
einem anorganischen Barrierematerial, einem Metall oder Aluminium oder
einem Oxid von Aluminium oder einem Oxid von Silizium oder
einem leitfähigen organischen oder anorganischen Material oder Kupfer.

## Revendications

1. Procédé de revêtement d'un substrat (2) comprenant la condensation d'une matière durcissable par irradiation (5') sur le substrat, **caractérisé par** le durcissement de ladite matière avec un flux électronique (6') ayant une énergie entre 6.5eV et 300eV, le flux électronique étant extrait d'un plasma gazeux à basse pression.

2. Procédé suivant la revendication 1, dans lequel le flux électronique (6') est dirigé sur le substrat (2) essentiellement simultanément à la délivrance de la matière sur le substrat, de manière que le durcissement est initié essentiellement concurremment dans l'espace et dans le temps avec la délivrance de la matière sur le substrat.

3. Procédé suivant la revendication 1, dans lequel le flux électronique (6') est dirigé sur le substrat (2) essentiellement séquentiellement avec la condensation de la matière sur ledit substrat.

4. Procédé suivant une quelconque des revendications 1 à 3, dans lequel le flux électronique (6') est dérivé d'un plasma gazeux basse pression avec une tension d'attaque qui est négative par rapport au substrat.

5. Procédé suivant la revendication 4 dans lequel le plasma gazeux basse pression est enrichi magnétiquement.

6. Procédé suivant la revendication 5, dans lequel le plasma gazeux basse pression est généré en utilisant un magnétron.

7. Procédé suivant la revendication 2, dans lequel essentiellement l'ensemble de la matière durcissable par radiation (5') passe à travers le flux (6') préalablement à la condensation sur la surface du substrat.

8. Procédé suivant une quelconque des revendications précédentes, dans lequel le substrat (2) comprend une âme composée d'un film plastique ;
ou composée de polyéthylène téréphtalate ou de polyester ou de polyethylene naphthalate ou d'un mélange de polyéthylène téréphtalate et de polyethylene naphthalate;
ou composée soit d'une polyoléfine, soit d'un polyamide ;
ou est obtenue d'une ressource renouvelable ou d'acide polylactique ou d'une cellulose; ou comprend une matière fibreuse, du papier ou du textile.

9. Procédé suivant une quelconque des revendications 1 à 7 dans lequel le substrat (2) comprend un film plastique qui est pré-revêtu
d'une matière barrière inorganique, d'un métal ou d'aluminium ; ou
d'un oxyde d'aluminium ou d'un oxyde de silicone ; ou
d'une matière conductrice organique ou inorganique ou de cuivre.
